(19)

Europäisches
Patentamt
European
Patent Office
Office européen
des brevets

(11)   **EP 2 416 330 A1**

(12)      **EUROPEAN PATENT APPLICATION**
published in accordance with Art. 153(4) EPC

(43) Date of publication:
     **08.02.2012 Bulletin 2012/06**

(51) Int Cl.:
     *H01G 5/40* (2006.01)        *H01G 5/16* (2006.01)
     *H01P 1/00* (2006.01)        *H03H 7/38* (2006.01)

(21) Application number: **10758519.2**

(22) Date of filing: **25.03.2010**

(86) International application number:
     **PCT/JP2010/055181**

(87) International publication number:
     **WO 2010/113746 (07.10.2010 Gazette 2010/40)**

(84) Designated Contracting States:
     **AT BE BG CH CY CZ DE DK EE ES FI FR GB GR
     HR HU IE IS IT LI LT LU LV MC MK MT NL NO PL
     PT RO SE SI SK SM TR**

(30) Priority: **30.03.2009 JP 2009082046**

(71) Applicant: **Murata Manufacturing Co., Ltd.
     Kyoto 617-8555 (JP)**

(72) Inventors:
     • **NAGAI Tomohiro
       Nagaokakyo-shi
       Kyoto 617-8555 (JP)**
     • **TONEGAWA Ken
       Nagaokakyo-shi
       Kyoto 617-8555 (JP)**
     • **HARADA Tetsuro
       Nagaokakyo-shi
       Kyoto 617-8555 (JP)**

(74) Representative: **Stöckeler, Ferdinand et al
     Patentanwälte Schoppe, Zimmermann,
     Stöckeler, Zinkler & Partner
     Postfach 246
     82043 Pullach (DE)**

(54)    **VARIABLE CAPACITANCE MODULE AND MATCHING CIRCUIT MODULE**

(57)      To inexpensively realize a small-sized variable capacitance module capable of certainly and inexpensively realizing necessary variable capacitance ranges.

A variable capacitance circuit (11) includes a variable capacitance element (Cv3) and fixed capacitance elements (Ce1, Ce2). The variable capacitance element (Cv3) and the fixed capacitance element (Ce1) are connected in series to each other, and the series circuit thereof and the fixed capacitance element (Ce2) are connected in parallel to each other. Accordingly, with reference to the capacitance of the fixed capacitance element (Ce2), the range of the combined capacitance of the variable capacitance circuit is given by a step size $\Delta C$ of capacitance based on the combined capacitance of the variable capacitance element (Cv3) and the fixed capacitance element (Ce1). At this time, the fixed capacitance elements (Ce1, Ce2) are realized using inner-layer flat-plate electrodes in a laminated substrate, and the variable capacitance element (Cv3) is realized using an MEMS element mounted on the top surface of the laminated substrate.

FIG. 1

EP 2 416 330 A1

## Description

Technical Field

This invention relates to a variable capacitance module realizing a capacitance value of a predetermined width and a matching circuit module including the variable capacitance module.

Background Art

In the past, as high-frequency transmitter and receiver modules, there have been various kinds of high-frequency modules, each of which transmits and receives, using one antenna, a plurality of communication signals utilizing frequency bands different from one another, respectively.

In such a high-frequency module, for example, if matching is not performed between the antenna and a transmitting and receiving circuit, it is difficult to transmit and receive a communication signal with a low loss. Here, if a transmission and reception environment is stable, a capacitance value used for matching is fixed theoretically. However, for example, when the high-frequency module such as a mobile phone is easily movable or the posture thereof can be easily changed, it is difficult to fully perform matching using the fixed capacitance. Therefore, for example, in an RFMEMS element described in PTL 1, an MEMS (Micro Electro Mechanical System) element is used as a capacitance element, a ground electrode and a movable electrode are formed whose electrode planes face each other, and a minute interval is arbitrarily set between the ground electrode and the movable electrode, thereby realizing a desired variable capacitance value necessary for matching.

Citation List

Patent Literature

PTL 1: Japanese Unexamined Patent Application Publication No. 2003-258502

Summary of Invention

Technical Problem

However, as described above, in the current high-frequency module, since the plural communication signals are transmitted and received using one antenna, it is necessary to make the capacitance value variable with respect to each communication signal. Therefore, a necessary variable capacitance range changes, and a capacitance range necessary as a high-frequency module becomes large. At this time, while a configuration is usually adopted in which a plurality of MEMS elements are formed and connected in parallel, the formation of the plural MEMS elements on a same substrate results in causing a substrate size to become large. In addition, as illustrated in the above-mentioned PTL 1, since the MEMS elements are formed on the basis of a semiconductor manufacturing process, the substrate size become large, thereby causing large cost increases. In addition, when the plural MEMS elements are formed on one substrate, a contribution component occurs and hence there occurs a problem that it is difficult to make capacitance variable in a wide frequency band.

Accordingly, an object of the present invention is to realize a variable capacitance module in which it is possible to certainly and inexpensively realize necessary various variable capacitance ranges. Furthermore, an object of the present invention is to realize a matching circuit module in which it is possible to certainly perform matching in necessary various impedance matching ranges using the variable capacitance module.

Solution to Problem

A variable capacitance module of this invention includes a variable capacitance element, a first fixed capacitance element, and a second fixed capacitance element. The variable capacitance element includes a predetermined variable capacitance width. The first fixed capacitance element is connected in series to the variable capacitance element, and is mounted in a laminated substrate in which the variable capacitance element is mounted, or is formed by an inner-layer flat-plate electrode in the laminated substrate. The second fixed capacitance element is connected in parallel to a series circuit of the variable capacitance element and the first fixed capacitance element, and is mounted in the laminated substrate in which the variable capacitance element is mounted, or is formed by an inner-layer flat-plate electrode in the laminated substrate.

More specifically, in particular, in the variable capacitance module of this invention, the variable capacitance element is formed by an MEMS element.

In this configuration, a variable capacitance circuit is formed by the variable capacitance element, the first fixed capacitance element, and the second fixed capacitance element. Here, when it is assumed that the capacitance of the variable capacitance element is Cv, the capacitance of the first fixed capacitance element is Cl, and the capacitance of the second fixed capacitance element is C2, a combined capacitance Cm as the variable capacitance circuit, namely, as the variable capacitance module, results in the following expression.

[Expression 1]

$$Cm = \frac{Cv}{1 + \dfrac{Cv}{C1}} + C2$$

Accordingly, compared with a case in which only the capacitance Cv of the variable capacitance element is simply used, the combined capacitance Cm of the variable capacitance module becomes diversified owing to the combination of the first fixed capacitance element and the second fixed capacitance element. In addition, only the variable capacitance element is the MEMS element, and the first fixed capacitance element and the second fixed capacitance element are realized using a usual chip part in which no MEMS element is used or the inner-layer flat-plate electrode formed in the laminated substrate. Therefore, compared with a case in which the whole is formed using a plurality of MEMS elements, the first fixed capacitance element and the second fixed capacitance element become inexpensive, and no parasitic capacitance also occurs.

In addition, in the variable capacitance element of the variable capacitance module of this invention, the variable capacitance width thereof is fixed. The second fixed capacitance element is set to a capacitance value that is the basis of a variable capacitance range desired as a module. The first fixed capacitance element is set to a capacitance value that determines a variable capacitance pitch desired as the module.

In this configuration, even if the number of the kinds of variable capacitance elements is one, the capacitances of the first fixed capacitance element and the second fixed capacitance element are arbitrarily set. Accordingly, it is possible to easily realize the variable capacitance range and the variable pitch, desired as the module.

In addition, the first fixed capacitance element and the second fixed capacitance element of the variable capacitance module of this invention are formed using the inner-layer flat-plate electrode and formed using an inner-layer flat-plate electrode shared by both the first fixed capacitance element and the second fixed capacitance element.

In this configuration, compared with a case in which the first fixed capacitance element and the second fixed capacitance element are individually formed, the inner-layer flat-plate electrode to be a connection end portion side on which these elements are connected are shared, and hence it is possible to perform downsizing. In addition, since there is no connection electrode pattern between the first fixed capacitance element and the second fixed capacitance element, there does not occur a problem that the connection electrode pattern is unnecessarily coupled with another electrode within the laminated substrate in a high-frequency manner, or the like, and it is possible to prevent characteristics from degrading.

In addition, the first fixed capacitance element and the second fixed capacitance element of the variable capacitance module of this invention are formed in a lower layer of an area where the variable capacitance element is mounted in the laminated substrate.

In this configuration, individual elements configuring the variable capacitance module are arranged in the laminating direction of the laminated substrate, and intensively disposed in a state in which the laminated substrate is viewed as a plan view. Therefore, it is possible to perform downsizing. In addition, since it is possible to shorten a connection electrode pattern for connecting individual elements configuring these variable capacitance modules, it is possible to prevent characteristics from degrading and the formation of the connection electrode pattern becomes easy. Accordingly, it is possible to realize a small-sized variable capacitance module excellent in a characteristic capable of realizing such a wide variety of variable capacitance ranges as described above.

In addition, the matching circuit module of this invention includes the above-mentioned variable capacitance module and an inductor formed or mounted in the laminated substrate. In addition, an LC circuit network is configured by connecting the variable capacitance module and the inductor using an electrode pattern formed in the laminated substrate.

In this configuration, the inductor is formed in the laminated substrate in which such a variable capacitance module as described above is formed, and only by connecting the variable capacitance module and the inductor to a predetermined circuit pattern, it is possible to form the matching circuit module. At this time, since, in the variable capacitance module, it is possible to realize such a wide variety of variable capacitance ranges as described above, it is also possible to variedly set the impedance matching range of the matching circuit module. Accordingly, it is possible to realize a small-sized matching circuit module in which it is possible to set a wide variety of impedance matching ranges.

In addition, the matching circuit module of this invention includes an open stub connected to the LC circuit network formed using a stub-use electrode formed in the laminate substrate.

In this configuration, the open stub is further connected to the LC circuit network, and hence it is possible to largely change an impedance matching range, in which matching can be performed in the LC circuit network, to an impedance matching range varying depending on the open stub. At this time, since a shift amount can be set in such a way as adjusting the line length of the open stub, it is possible to set a wider variety of impedance matching ranges. At this time, since the open stub is formed using the stub-use electrode formed in the laminated substrate, the size of the matching circuit module does not become large drastically. Namely, with preventing an occupied area form growing in size, it is possible to realize a matching circuit module in which impedance matching is arbitrarily performed within an even wider impedance matching range.

In addition, the matching circuit module of this invention uses, as the open stub, a plurality of open stubs where electrode lengths of the stub-use electrodes are individually different from one another.

In this configuration, by providing the plural open stubs, it is possible to set a wider variety of impedance matching ranges.

In addition, in the matching circuit module of this invention, a switch element is provided between the LC circuit network and the open stub.

In this configuration, if the open stub is separated from the LC circuit network by the switch element, the impedance matching range of the independent LC circuit network is set. In addition, if the open stub is connected to the LC circuit network by the switch element, it is possible to largely change the impedance matching range of the independent LC circuit network to an impedance matching range varying depending on the open stub. Accordingly, since two impedance matching ranges are set owing to the on-off control of the switch element, it is possible to perform matching in an even wider impedance matching range.

In addition, in the matching circuit module of this invention uses, an electrode length of the stub-use electrode is set so that impedance matching ranges switched by the open stub do not overlap with each other.

In this configuration, it is possible to effectively realize the magnification of the impedance matching range based on the switch element, on the basis that impedance matching ranges based on the above-mentioned on-off control of the switch element do not overlap with each other.

In addition, the inductor of the matching circuit module of this invention is formed by an inductor-use electrode formed in the laminated substrate, and the inductor-use electrode and the stub-use electrode are formed so as not to overlap with each other when the laminated substrate is viewed as a plan view.

In this configuration, since the electrode plane of the inductor-use electrode and the electrode plane of the stub-use electrode do not face each other, the inductor and the open stub are hardly coupled with each other in a high-frequency manner, and it is possible to easily design a circuit realizing a desired impedance matching range.

In addition, in the matching circuit module of this invention, the stub-use electrode and the inner-layer flat-plate electrode forming the first fixed capacitance element and the second fixed capacitance element are formed so as not to overlap with each other when the laminated substrate is viewed as a plan view.

According to this configuration, since the inner-layer flat-plate electrode forming the first fixed capacitance element and the second fixed capacitance element does not face the stub-use electrode, the first fixed capacitance element and the second fixed capacitance element are hardly coupled with the open stub in a high-frequency manner, and it is possible to easily design a circuit realizing a desired impedance matching range.

Advantageous Effects of Invention

According to this invention, it is possible to certainly and inexpensively realize a variable capacitance module in which necessary various variable capacitance ranges can be set. Furthermore, using such a variable capacitance module, it is possible to certainly and inexpensively realize a matching circuit module with a small size, in which necessary various impedance matching ranges can be set.

Brief Description of Drawings

[Fig. 1] Fig. 1 is an equivalent circuit diagram of a matching circuit module 1 according to an embodiment of the present invention.
[Fig. 2] Fig. 2 is a lamination diagram of the matching circuit module 1 according to an embodiment of the present invention.
[Fig. 3] Fig. 3 is a diagram illustrating characteristics of combined capacitance Ct and a step size $\Delta$C of a capacitance in a variable capacitance circuit, due to various kinds of combinations of a variable capacitance element Cv, a series fixed capacitance element Cse series-connected to the corresponding variable capacitance element Cv, and a parallel fixed capacitance element Csh in parallel with a series circuit based on these variable capacitance element Cv and series fixed capacitance element Cse.
[Fig. 4] Fig. 4 is a diagram illustrating the change of an impedance-matching range due to the presence or absence of the connection of an open stub Stub and the change of the length of the open stub Stub.
[Fig. 5] Fig. 5 is a block diagram illustrating the variation of the open stub Stub.
[Fig. 6] Fig. 6 is a circuit diagram illustrating the variation of an LC circuit network.

Description of Embodiments

A matching circuit module according to an embodiment of the present invention will be described with reference to drawings.

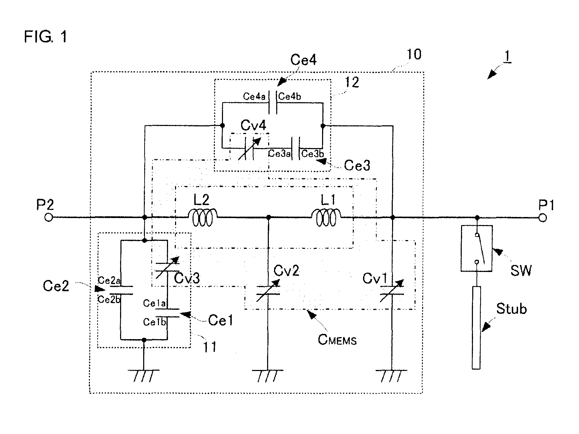

Fig. 1 is the equivalent circuit diagram of a matching circuit module 1 of the present embodiment. As illustrated in Fig. 1, the matching circuit module 1 of the present embodiment includes a first input-output port P1 and a second input-output port P2, and has a circuit configuration in which an LC circuit network 10 is inserted between the first input-output port P1 and the second input-output port P2. One end portion of a switch element SW is connected to an end portion on the first input-output port P1 side of the LC circuit network 10, and an open stub Stub is connected to the other end portion of the switch SW.

The LC circuit network 10 includes an inductor L1 and an inductor L2, connected in series between the first input-output port P1 and the second input-output port P2. At this time, a first input-output port P1 side is the inductor L1, and a second input-output port P2 side is the inductor L2.

A variable capacitance element Cv1 is connected between an end portion on the first input-output port P1 side of the inductor L1 and ground. A variable capacitance element Cv2 is connected between a connection point between the inductor L1 and the inductor L2 and the ground.

A variable capacitance circuit 11 configuring a "variable capacitance module" of the present invention is connected between an end portion on the second input-output port P2 side of the inductor L2 and the ground. In the variable capacitance circuit 11, a fixed capacitance element Ce2 (corresponding to a second fixed capacitance element of the present invention) is connected in parallel to a series circuit including a fixed capacitance element Ce1 (corresponding to a first fixed capacitance element of the present invention) and a variable capacitance element Cv3.

In addition, a variable capacitance circuit 12 is connected in parallel to a series circuit including the inductors L1 and L2. In the variable capacitance circuit 12, a fixed capacitance element Ce4 (corresponding to the second fixed capacitance element of the present invention) is connected in parallel to a series circuit including a fixed capacitance element Ce3 (corresponding to the first fixed capacitance element of the present invention) and a variable capacitance element Cv4.

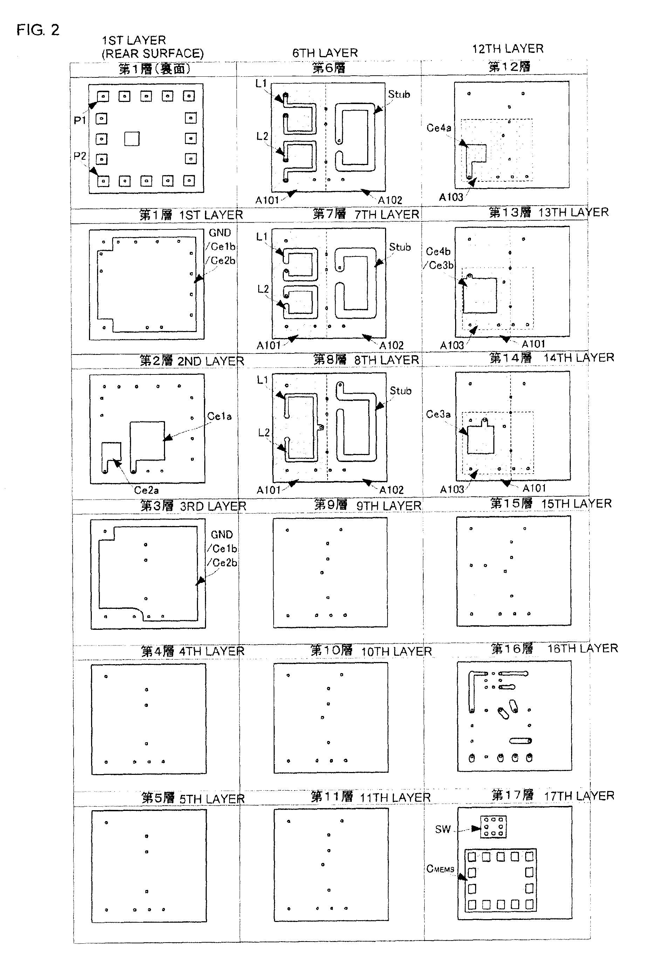

Next, the mechanical configuration of the matching circuit module of the present embodiment will be described with reference to Fig. 2. In addition, Fig. 2 is the lamination diagram of the matching circuit module 1 of the present embodiment. In Fig. 2, it is assumed that a lowermost layer is a first layer and an uppermost layer is a 17the layer, and a form is described in which a layer number increases from a lower layer side. In addition, symbols O described in individual layers in Fig. 2 indicate via holes, and fulfill functions for conductively connecting electrode patterns formed on individual insulation layers to one another in a laminating direction.

As illustrated in Fig. 2, the matching circuit module 1 includes a laminated substrate including 17 layers. On the rear surface of the first layer of the laminated substrate 1, namely, the mounting surface of the matching circuit module 1 itself, lands used for mounting the matching circuit module 1 itself are formed. On the rear surface of the first layer, lands corresponding to the first input-output port P1 and the second input-output port P2 are also formed.

On the front surface of the first layer, a ground electrode GND is formed on almost the whole surface that does not overlap with the lands to be the first input-output port P1 and the second input-output port P2 when being viewed from the laminating direction. The ground electrode GND doubles as one electrode Ce1b configuring a facing electrode of the fixed capacitance element Ce1 and one electrode Ce2b configuring a facing electrode of the fixed capacitance element Ce2.

On the front surface of the second layer, the other electrode Ce1a configuring a facing electrode of the fixed capacitance element Ce1 and the other electrode Ce2a configuring a facing electrode of the fixed capacitance element Ce2 are formed using a flat-plate electrode pattern having a predetermined shape.

On the front surface of the third layer, the ground electrode GND is formed using almost the same shape as the first layer front surface. The ground electrode GND doubles as one electrode Ce1b configuring a facing electrode of the fixed capacitance element Ce1 and one electrode Ce2b configuring a facing electrode of the fixed capacitance element Ce2.

Using the first layer to the third layer in such a way, the fixed capacitance elements Ce1 and Ce2 are formed.

In the fourth layer and the fifth layer, via holes are only formed. Accordingly, the formation area of the fixed capacitance elements Ce1 and Ce2 and the formation area of the inductors L1 and L2 and the open stub Stub, subsequently illustrated, are disposed with being separated by two layers in the laminating direction.

When being viewed from the laminating direction, each of the sixth layer to the eighth layer is separated into two areas by via holes connected to the ground electrodes, and line electrode patterns configuring the inductors L1 and L2 are formed in a first area A101. In addition, a line electrode pattern configuring the open stub Stub is formed in a second area A102. Namely, the line electrode pattern of the inductors L1 and L2 and the line electrode pattern of the open stub Stub are formed so as not to overlap with each other when being viewed from the laminating direction. In this way, the open stub Stub and the inductors L1 and L2 are disposed so as to be separated into the first area A101 and the second area A102, and hence it is possible to improve the isolation of the two. In addition, by being separated using via holes connected to the ground electrodes, it is possible to further improve the isolation characteristic. Furthermore, the line electrode pattern of the inductor L1 and the line electrode pattern of the inductor L2 are also formed so as not to overlap with each other when being viewed from the laminating direction.

In addition, the line electrode pattern of the open stub Stub is formed so as to become wider than the line electrode pattern of the inductors L1 and L2.

In the ninth layer, the 10th layer, and the 11th layer, via holes are only formed. Accordingly, the formation area of the inductors L1 and L2 and the open stub Stub and the formation area of the fixed capacitance elements Ce3 and Ce4 subsequently illustrated are disposed with being separated by three layers in the laminating direction.

In the first area A101 in the 12th layer, one electrode Ce4a of a facing electrode of the fixed capacitance element Ce4 is formed using a flat-plate electrode pattern having a predetermined shape. At this time, one electrode Ce4a of the fixed capacitance element Ce4 is formed so as to be disposed in a third area A103 that is the same mounting area as the that of an MEMS element in the 17th layer, the 17th layer being the uppermost layer when being viewed from the laminating direction.

In the third area A103 in the first area A101 in the 13th layer, the other electrode Ce4b of a facing electrode of the fixed capacitance element Ce4 is formed using a flat-plate electrode pattern having a predetermined shape. The other electrode Ce4b of the fixed capacitance element Ce4 doubles as one electrode Ce3b of a facing electrode of the fixed capacitance element Ce3.

In the third area A103 in the first area A101 in the 14the layer, the other electrode Ce3a of a facing electrode of the fixed capacitance element Ce3 is formed using a flat-plate electrode pattern having a predetermined shape.

Via holes are only formed in the 15th layer, and via holes and a drawing electrode pattern are only formed in the 16th layer.

On the front surface of the 17th layer, namely, on the top surface of the laminated substrate configuring the matching circuit module 1, land electrodes on which a switch element SW and an MEMS element $C_{MEMS}$ equipped with the variable capacitance elements Cv1 to Cv4 are mounted are formed, and the switch element SW and the MEMS element $C_{MEMS}$ are mounted on lands individually corresponding thereto.

In this way, using the configuration of the present embodiment, the inductors L1 and L2, the stub Stub, and the fixed capacitance elements Ce1 to Ce4 are realized on the basis of the electrodes within the laminated substrate, and the variable capacitance elements Cv1 to Cv4 are realized on the basis of the MEMS element that is one component mounted on the laminated substrate.

Next, the variable capacitance circuit will be described that is a characteristic functional unit in the matching circuit module of the present embodiment.

The variable capacitance circuits 11 and 12 series-connect the fixed capacitance elements to the variable capacitance elements, and connect in parallel the fixed capacitance elements to the corresponding serial connection circuits. Therefore, while these variable capacitance circuits are simply configured using only the variable capacitance element Cv3 and the variable capacitance element Cv4, it is possible to realize a wide variety of capacitance.

For example, by regarding the symbols of individual capacitance elements as the individual capacitances thereof, the combined capacitance Ctl1 of the variable capacitance circuit 11 is obtained on the basis of the following expression.

[Expression 2]

$$Ct11 = \frac{Cv3}{1 + \frac{Cv3}{Ce1}} + Ce2$$

The combined capacitance of the variable capacitance circuit 11 is set in such a way as described above. Accordingly, by arbitrarily setting the capacitance of the fixed capacitance element Ce2, it is possible to set the maximum capacitance of the combined capacitance of the variable capacitance circuit 11. In addiction, by arbitrarily setting the capacitance of the fixed capacitances element Ce1, it is possible to set the capacitance step size $\Delta C$ of the variable capacitance circuit 11. At this time, even if the value of the variable capacitance element Cv3 and the step size thereof are not changed, it is possible to set a step size different from the capacitance step size $\Delta C$ of only the variable capacitance element Cv3.

In addition, the combined capacitance Ct12 of the variable capacitance circuit 12 is calculated on the basis of the following expression.

[Expression 3]

$$Ct12 = \frac{Cv4}{1 + \frac{Cv4}{Ce3}} + Ce4$$

The combined capacitance of the variable capacitance circuit 12 is set in such a way. Accordingly, by arbitrarily setting the capacitance of the fixed capacitance element Ce4, it is possible to set the maximum capacitance of the combined capacitance of the variable capacitance circuit 12. In addition, by arbitrarily setting the capacitance of the fixed capacitance element Ce3, it is possible to set the capacitance step size $\Delta C$ of the variable capacitance circuit 11. At this time, even if the value of the variable capacitance element Cv4 and the step size thereof are not changed, it is possible to set a step size different from the capacitance step size $\Delta C$ of only the variable capacitance element Cv4.

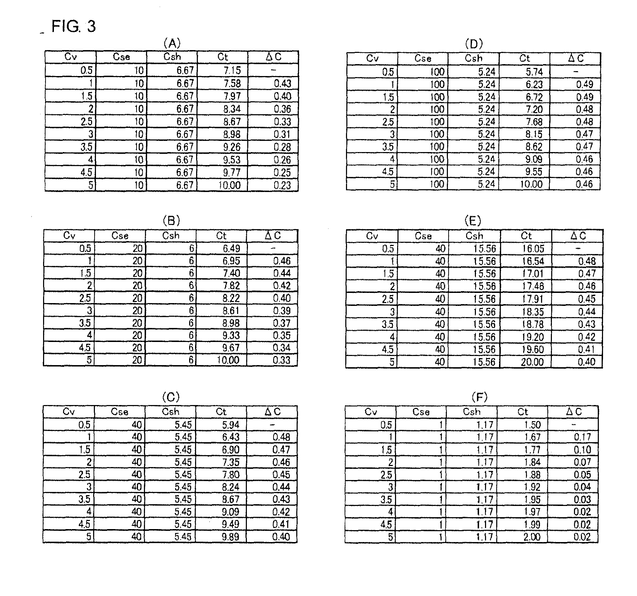

For example, Figs. 3(A) to 3(F) are diagrams illustrating characteristics of the combined capacitance Ct and the step size $\Delta C$ of a capacitance in a variable capacitance circuit, due to various kinds of combinations of a variable capacitance element Cv, a series fixed capacitance element Cse series-connected to the corresponding variable capacitance element Cv, and a parallel fixed capacitance element Csh in parallel with a series circuit based on these variable capacitance element Cv and series fixed capacitance element Cse, and all the units thereof are [pF]. In Figs. 3(A) to 3(F), the variable capacitance element Cv is set to a characteristic that capacitance varies from 0.5 pF to 5.0 pF in steps of 0.5 pF.

In Fig. 3(A), the capacitance of the series fixed capacitance element Cse is 10 pF, and the parallel fixed capacitance element Csh is 6.67 pF. By performing such a capacitance setting as described above, as illustrated in Fig. 2(A), the combined capacitance Ct as the variable capacitance circuit varies between 7.15 pF to 10.00 pF, and it is possible to set the capacitance step size ΔC at between 0.43 pF and 0.23 pF. Accordingly, it is possible to set a capacitance range different from capacitance that can be simply realized using only the variable capacitance element Cv.

In Fig. 3(B), the capacitance of the series fixed capacitance element Cse is 20 pF, and the parallel fixed capacitance element Csh is 6 pF. By performing such a capacitance setting as described above, as illustrated in Fig. 3(B), the combined capacitance Ct as the variable capacitance circuit varies between 6.49 pF to 10.00 pF, and it is possible to set the capacitance step size ΔC at between 0.46 pF and 0.33 pF. Accordingly, it is possible to make the capacitance step size ΔC wider than the setting illustrated in Fig. 3(A), and it is possible to widen the settable capacitance range by about 0.5 pF.

In addition, in Fig. 3(C), the capacitance of the series fixed capacitance element Cse is 40 pF, and the parallel fixed capacitance element Csh is 5.45 pF. By performing such a capacitance setting as described above, as illustrated in Fig. 3(C), the combined capacitance Ct as the variable capacitance circuit varies between 5.94 pF to 9.89 pF, and it is possible to set the capacitance step size ΔC at between 0.48 pF and 0.40 pF. Accordingly, it is possible to make the capacitance step size ΔC wider than the setting illustrated in Fig. 3 (B), and it is possible to make the sellable capacitance range about 0.5 pF wider than Fig. 3(B).

In addition, in Fig. 3(D), the capacitance of the series fixed capacitance element Cse is 100 pF, and the parallel fixed capacitance element Csh is 5.24 pF. By performing such a capacitance setting as described above, as illustrated in Fig. 3(D), the combined capacitance Ct as the variable capacitance circuit varies between 5.74 pF to 10.00 pF, and it is possible to set the capacitance step size ΔC at between 0.49 pF and 0.46 pF. Accordingly, it is possible to realize almost the same capacitance range as the setting illustrated in Fig. 3(C), and it is possible to maintain the capacitance step size ΔC nearly constant.

In addition, in Fig. 3(E), the capacitance of the series fixed capacitance element Cse is 40 pF, and the parallel fixed capacitance element Csh is 15.56 pF. By performing such a capacitance setting as described above, as illustrated in Fig. 3(E), the combined capacitance Ct as the variable capacitance circuit varies between 16.05 pF to 20.00 pF, and it is possible to set the capacitance step size ΔC at between 0.48 pF and 0.40 pF. Accordingly, it is possible to realize the same capacitance range as the setting illustrated in Fig. 3(C), and it is possible to realize another capacitance range that does not overlap with the capacitance range illustrated in Fig. 3(C).

In addition, in Fig. 3(F), the capacitance of the series fixed capacitance element Cse is 1 pF, and the parallel fixed capacitance element Csh is 1.17 pF. By performing such a capacitance setting as described above, as illustrated in Fig. 3(F), the combined capacitance Ct as the variable capacitance circuit varies between 1.50 pF to 2.00 pF, and it is possible to set the capacitance step size ΔC at between 0.17 pF and 0.02 pF. Accordingly, it is possible to realize a low capacitance range difficult to realize in the case of only the variable capacitance element Cv or using the capacitance ranges illustrated in Figs. 3(A) to 3(E). Furthermore, it is possible to realize a capacitance step size ΔC shorter than in the case of only the variable capacitance element Cv and those illustrated in Figs. 3(A) to 3(E).

In such a way as described, using the configuration of the present embodiment, without replacing a variable capacitance element, it is possible to realize a wide variety of capacitance ranges and the step sizes ΔC of capacitance, compared with a case in which a simple variable capacitance element is independently used.

Here, if such a wide variety of capacitance ranges and the step sizes ΔC of capacitance are realized using a variable capacitance element group including an MEMS element, the number of variable capacitance elements greatly increases. Therefore, the size of the MEMS element becomes large, thereby causing large cost increases.

However, according to the configuration of the present embodiment, as described above, a wide variety of capacitance ranges and the step sizes ΔC of capacitance are realized on the basis of the combinations of the fixed capacitance elements and the variable capacitance elements. In addition, as illustrated in Fig. 2 described above, the fixed capacitance element is realized using the inner-layer flat-plate electrode formed within the laminated substrate, and hence it is possible to inexpensively realize the fixed capacitance element portion of the variable capacitance circuit with a simple configuration. Accordingly, compared with a case in which a variable capacitance circuit (variable capacitance module) is formed from the variable capacitance element group including an MEMS element, it is possible to realize a variable capacitance circuit with a small size and a low price.

In addition, at this time, as illustrated in the 12th layer to the 17th layer in Fig. 2 described above, the mounting area of the MEMS element within which the variable capacitance element Cv4 is packaged and the formation area of the fixed capacitance elements Ce3 and Ce4 are caused to overlap with each other when being viewed from the laminating direction, and hence the connection lines between the variable capacitance element Cv4 and the fixed capacitance elements Ce3 and Ce4 that configure the variable capacitance circuit 12 are formed about only in the laminating direction. Therefore, it is possible to realize the variable capacitance circuit 12 using extremely short connection lines. Accordingly, it is possible to largely reduce the coupling of the connection lines to another circuit element or an electrode, and it is possible to reduce an area when being viewed from the laminating direction. As a result, it is possible to form a small-sized variable capacitance circuit (variable capacitance module) capable of realizing desired capacitance with a high degree of accuracy.

Furthermore, in this variable capacitance circuit 12, one of the facing electrodes of each of the fixed capacitance elements Ce3 and Ce4 is shared by the fixed capacitance elements Ce3 and Ce4. Therefore, the connection line between the fixed capacitance elements Ce3 and Ce4 is not necessary, and it is possible to realize a variable capacitance module with a high degree of accuracy and a small size.

Next, the characteristics of a variable matching circuit module including a variable capacitance circuit (variable capacitance module) having such a feature will be described.

When the capacitances of such the variable capacitance circuits 11 and 12, the inductances of the individual inductors L1 and L2, the variable capacitance elements Cv1 and Cv2, and the capacitances of the variable capacitance circuits 11 and 12 are arbitrarily set, the LC circuit network 10 can realize impedance in which a desired matching characteristic can be obtained. At this time, only the variable capacitance elements Cv1 to Cv4 are not simply used but such the variable capacitance circuits 11 and 12 as described above are used, thereby realizing a wider variety of impedance-matching ranges.

Here, since the variable capacitance circuits 11 and 12 included in the LC circuit network 10 are realized using electrodes packaged within the laminated substrate and the MEMS element mounted in the laminated substrate, as described above, the laminated substrate realizing the matching circuit module 1, the characteristics of the variable capacitance circuits 11 and 12 are improved compared with a case in which the variable capacitance circuits 11 and 12 are individually formed and connected, and the variable capacitance circuits 11 and 12 can be downsized.

Furthermore, in the matching circuit module 1 of the present embodiment, the open stub Stub is connected on the first input-output port P1 side of the LC circuit network 10 through the switch element SW, and hence it is possible to largely change an impedance-matching range based on the open stub Stub.

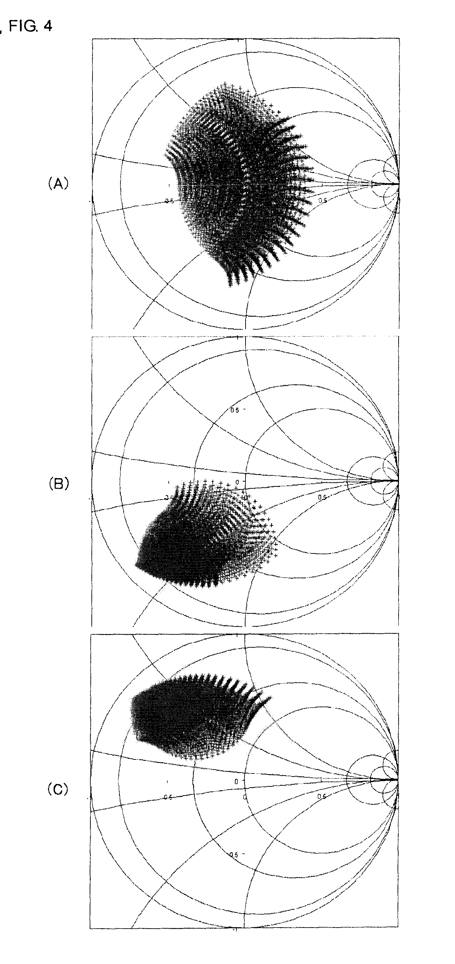

Fig. 4 is a diagram illustrating the change of an impedance-matching range due to the presence or absence of the connection of the open stub Stub and the change of the length of the open stub Stub, at the frequency of 1 GHz. In Fig. 4, a range indicated by a group including symbols x on a Smith chart indicates a range in which impedance matching can be performed. Fig. 4(A) illustrates a case in which the open stub Stub is not connected. Fig. 4(B) illustrates a case in which the open stub Stub of 100 mm is connected, and Fig. 4(C) illustrates a case in which the open stub Stub of 200 mm is connected.

As illustrated in Fig. 4, depending on the case in which the open stub Stub is connected and on the case in which the open stub Stub is not connected, the range in which impedance matching can be performed varies. Furthermore, depending on the line length of the connected open stub Stub, the range in which impedance matching can be performed also varies.

By connecting the open stub Stub in such a way as described above, it is possible to realize an impedance-matching range different from the LC circuit network 10. Furthermore, by arbitrarily adjusting the electric length of the connected open stub Stub, it is possible to realize an impedance-matching range varying depending on the line length. Accordingly, it is possible to realize a wider variety of impedance-matching ranges. At this time, since the open stub Stub is realized using a line electrode packaged within the laminated substrate, it is possible to realize it with a simple structure. Since the open stub Stub is formed in a plurality of layers, the electric length can be adjusted only by changing the number of layers in which line electrode patterns are formed. Therefore, it is possible to realize various kinds of electric lengths without changing a size when being viewed from the laminating direction. Accordingly, it is possible to realize a small-sized matching circuit module capable of realizing a wide variety of impedance-matching ranges.

In addition, furthermore, by controlling the connection and non-connection of the open stub Stub on the basis of the switch element SW, when, for example, the open stub Stub whose line length is 100 mm illustrated in Fig. 4 is used, it is possible to realize the impedance-matching range illustrated in Fig. 4(A) and the impedance-matching range illustrated in Fig. 4(B), only using the switching of the switch element SW. Accordingly, it is possible to realize a matching circuit module having a wider variety of and broader impedance-matching ranges. At this time, since the switch element SW is mounted on the laminated substrate, a size when being viewed from the laminating direction does not depend on the presence or absence of the switch element SW. Accordingly, it is possible to realize a matching circuit module having a wide variety of and broader impedance-matching ranges, without growing in size.

In addition, when such switching is performed, the electric length is set so that impedance-matching ranges individually obtained on the basis of the connection and non-connection of the open stub Stub do not overlap with each other. Therefore, it is possible to realize an even broader impedance-matching range.

Incidentally, as described above, the line electrode pattern configuring the inductors L1 and L2 of the LC circuit network 10 and the line electrode pattern configuring the open stub Stub are formed in areas different when being viewed from the laminating direction, so as not to overlap with each other when being viewed from the laminating direction. Therefore, it is possible to reduce coupling between the inductors L1 and L2 and the open stub Stub. Accordingly, it is possible to realize the inductances of the inductors L1 and L2 and the open stub Stub with a high degree of accuracy so that the inductances become desired values. As a result, it is possible to obtain a high-precision impedance matching characteristic also as a matching circuit module.

Furthermore, as illustrated in the 6th layer to the 14th layer, the open stub Stub and each of the fixed capacitance elements Ce3 and Ce4 are formed in areas different when being viewed from the laminating direction, so as not to overlap with each other when being viewed from the laminating direction. Therefore, it is possible to reduce coupling between the fixed capacitance elements Ce3 and Ce4 and the open stub Stub. As a result, it is possible to obtain a higher-precision impedance matching characteristic as the matching circuit module.

As described above, using the configuration of the present embodiment, it is possible to inexpensively realize a small-sized matching circuit module capable of realizing a wider variety of and broader impedance-matching ranges.

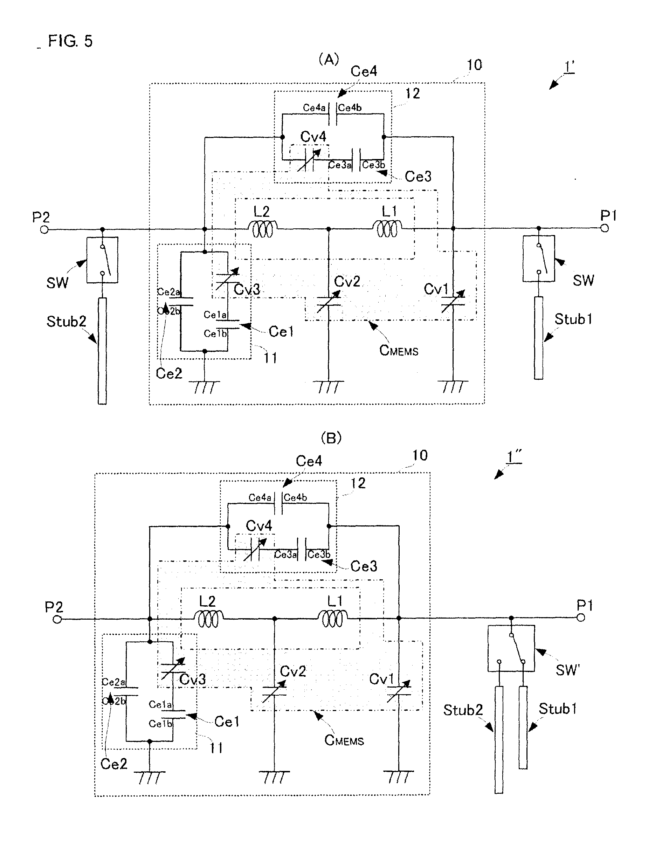

In addition, while, in the above-mentioned embodiment, an example has been illustrated in which the formation number of open stubs Stub is one, a plurality of open stubs Stub may also be formed as illustrated in Fig. 5. Fig. 5 is a block diagram illustrating the variation of the open stub Stub.

For example, in the configuration of a matching circuit module 1' illustrated in Fig. 5(A), an open stub Stub1 is connected on the first input-output port P1 side of the LC circuit network 10 through the switch element SW, and an open stub Stub2 is connected on the second input-output port P2 side thereof. The electric lengths of these open stubs Stub and Stub2 may be identical to or different from each other, and may be arbitrarily set in accordance with a desired impedance-matching range. In addition, by causing the electric lengths of the open stubs Stub1 and Stub2 to be different from each ocher, it is possible to realize an even broader impedance-matching range on the basis of the combination of the control of two switches SW.

In addition, in the configuration of a matching circuit module 1" illustrated in Fig. 5(B), by toggling between the open stub Stubs 1 and 2 whose electric lengths are different from each other on the basis of a switch element SW on the first input-output port P1 side of the LC circuit network 10, it is possible to realize impedance-matching ranges different from each other, respectively. Even in such a configuration, it is possible to realize an even broader impedance-matching range. In addition, the number of the open stubs Stub is not necessarily one or two in such a way, and the number of the open stubs Stub may also be greater than or equal to three. Furthermore, the configuration illustrated in Fig. 5(A) and the configuration illustrated in Fig. 5(B) may be combined with each other.

In addition, while, in the description of the above-mentioned embodiment, a case has been illustrated in which the variable capacitance elements Cv1 and Cv2 are independently used and the variable capacitance elements Cv3 and Cv4 are transformed into the variable capacitance circuits 11 and 12 (variable capacitance modules), all variable capacitance elements may also be transformed into variable capacitance circuits. Accordingly, it is possible to realize a wider variety of capacitance, and in response to this, it is possible to realize a wide variety of impedance-matching ranges.

In addition, while, in the description of the above-mentioned embodiment, a case has been illustrated in which the fixed capacitance elements Ce1 to Ce4 of the variable capacitance circuits 11 and 12 are formed using the inner-layer flat-plate electrodes in the laminated substrate, the fixed capacitance elements Ce1 to Ce4 may also be realized using discrete components mounted on the laminated substrate, so as to obtain desired capacitance.

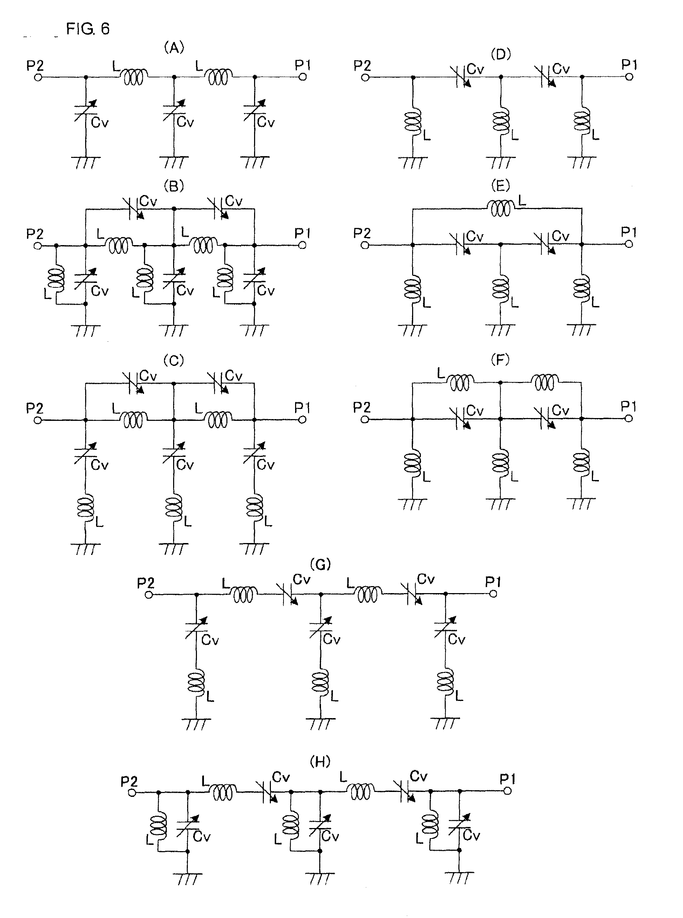

In addition, the above-mentioned LC circuit network 10 is an example for realizing a desired impedance-matching range, and as illustrated in Fig. 6, it is possible to realize various kinds of circuit configurations on the basis of the combinations of inductor, variable capacitance circuits, and variable capacitance elements. Fig. 6 is a circuit diagram illustrating the variation of an LC circuit network. In addition, while, in the drawing, all inductors are indicated by circuit symbols L, and all variable capacitance elements are indicated by circuit symbols Cv, each of the element values thereof may be arbitrarily set in response to a desired characteristic. In addition, all the circuit symbols indicating the variable capacitance elements Cv in the drawing may be the above-mentioned variable capacitance circuit, and the variable capacitance circuit and an independent variable capacitance element may also be arbitrarily combined with each other.

As illustrated in Fig. 6, by arbitrarily combining the inductors, the variable capacitance circuits, and the variable capacitance elements with one another, it is possible to set a wider variety of desired impedance-matching ranges.

Reference Signs List

1, 1', 1" " matching circuit module
10 LC circuit network
11, 12 variable capacitance circuit
L1, L2 inductor
Cv1 to Cv4 variable capacitance element
Ce1 to Ce4 fixed capacitance element
Stub, Stub1, Stub2 open stub
SW, SW' switch element

**Claims**

1. A variable capacitance module comprising:

   a variable capacitance element including a predetermined variable capacitance width formed by an MEMS element;
   a first fixed capacitance element connected in series to the variable capacitance element, and mounted in a laminated substrate in which the variable capacitance element is mounted, or formed by an inner-layer flat-plate electrode in the laminated substrate; and
   a second fixed capacitance element connected in parallel to a series circuit of the variable capacitance element and the first fixed capacitance element, and mounted in the laminated substrate in which the variable capacitance element is mounted, or formed by an inner-layer flat-plate electrode in the laminated substrate.

2. The variable capacitance module according to Claim 1, wherein
   the variable capacitance width of the variable capacitance element is fixed,
   the second fixed capacitance element is set to a capacitance value that is the basis of a variable capacitance range desired as a module, and
   the first fixed capacitance element is set to a capacitance value determining a variable capacitance pitch desired as the module.

3. The variable capacitance module according to any one of Claim 1 and Claim 2, wherein
   both the first fixed capacitance element and the second fixed capacitance element are formed using the inner-layer flat-plate electrode and formed using an inner-layer flat-plate electrode shared by both the first fixed capacitance element and the second fixed capacitance element.

4. The variable capacitance module according to Claim 3, wherein
   the first fixed capacitance element and the second fixed capacitance element are formed in a lower layer of an area where the variable capacitance element is mounted in the laminated substrate.

5. The variable capacitance module according to any one of Claim 1 to Claim 4, wherein
   an MEMS element is used as the variable capacitance element.

6. A matching circuit module comprising:

   the variable capacitance module described in any one of Claim 1 to Claim 5; and
   an inductor formed or mounted in the laminated substrate, wherein
   an LC circuit network is configured by connecting the variable capacitance module and the inductor using an electrode pattern formed in the laminated substrate.

7. The matching circuit module according to Claim 6, further comprising:

   an open stub connected to the LC circuit network formed using a stub-use electrode formed in the laminated substrate.

8. The matching circuit module according to Claim 7, wherein
   the open stub includes a plurality of open stubs where electrode lengths of the stub-use electrodes are individually different from one another.

9. The matching circuit module according to any one of Claim 7 and Claim 8, wherein
   a switch element is provided between the LC circuit network and the open stub.

10. The matching circuit module according to Claim 9, wherein
    an electrode length of the stub-use electrode is set so that impedance matching ranges switched by the open stub do not overlap with each other.

11. The matching circuit module according to any one of Claim 6 to Claim 10, wherein
    the inductor is formed by an inductor-use electrode formed in the laminated substrate, and
    the inductor-use electrode and the stub-use electrode are formed so as not to overlap with each other when the laminated substrate is viewed as a plan view.

12. The matching circuit module according to any one of Claim 6 to Claim 11, wherein
    the stub-use electrode and the inner-layer flat-plate electrode forming the first fixed capacitance element and the second fixed capacitance element are formed so as not to overlap with each other when the laminated substrate is viewed as a plan view.

FIG. 1

FIG. 2

## FIG. 3

**(A)**

| Cv | Cse | Csh | Ct | ΔC |
|---|---|---|---|---|
| 0.5 | 10 | 6.67 | 7.15 | – |
| 1 | 10 | 6.67 | 7.58 | 0.43 |
| 1.5 | 10 | 6.67 | 7.97 | 0.40 |
| 2 | 10 | 6.67 | 8.34 | 0.36 |
| 2.5 | 10 | 6.67 | 8.67 | 0.33 |
| 3 | 10 | 6.67 | 8.98 | 0.31 |
| 3.5 | 10 | 6.67 | 9.26 | 0.28 |
| 4 | 10 | 6.67 | 9.53 | 0.26 |
| 4.5 | 10 | 6.67 | 9.77 | 0.25 |
| 5 | 10 | 6.67 | 10.00 | 0.23 |

**(D)**

| Cv | Cse | Csh | Ct | ΔC |
|---|---|---|---|---|
| 0.5 | 100 | 5.24 | 5.74 | – |
| 1 | 100 | 5.24 | 6.23 | 0.49 |
| 1.5 | 100 | 5.24 | 6.72 | 0.49 |
| 2 | 100 | 5.24 | 7.20 | 0.48 |
| 2.5 | 100 | 5.24 | 7.68 | 0.48 |
| 3 | 100 | 5.24 | 8.15 | 0.47 |
| 3.5 | 100 | 5.24 | 8.62 | 0.47 |
| 4 | 100 | 5.24 | 9.09 | 0.46 |
| 4.5 | 100 | 5.24 | 9.55 | 0.46 |
| 5 | 100 | 5.24 | 10.00 | 0.46 |

**(B)**

| Cv | Cse | Csh | Ct | ΔC |
|---|---|---|---|---|
| 0.5 | 20 | 6 | 6.49 | – |
| 1 | 20 | 6 | 6.95 | 0.46 |
| 1.5 | 20 | 6 | 7.40 | 0.44 |
| 2 | 20 | 6 | 7.82 | 0.42 |
| 2.5 | 20 | 6 | 8.22 | 0.40 |
| 3 | 20 | 6 | 8.61 | 0.39 |
| 3.5 | 20 | 6 | 8.98 | 0.37 |
| 4 | 20 | 6 | 9.33 | 0.35 |
| 4.5 | 20 | 6 | 9.67 | 0.34 |
| 5 | 20 | 6 | 10.00 | 0.33 |

**(E)**

| Cv | Cse | Csh | Ct | ΔC |
|---|---|---|---|---|
| 0.5 | 40 | 15.56 | 16.05 | – |
| 1 | 40 | 15.56 | 16.54 | 0.48 |
| 1.5 | 40 | 15.56 | 17.01 | 0.47 |
| 2 | 40 | 15.56 | 17.46 | 0.46 |
| 2.5 | 40 | 15.56 | 17.91 | 0.45 |
| 3 | 40 | 15.56 | 18.35 | 0.44 |
| 3.5 | 40 | 15.56 | 18.78 | 0.43 |
| 4 | 40 | 15.56 | 19.20 | 0.42 |
| 4.5 | 40 | 15.56 | 19.60 | 0.41 |
| 5 | 40 | 15.56 | 20.00 | 0.40 |

**(C)**

| Cv | Cse | Csh | Ct | ΔC |
|---|---|---|---|---|
| 0.5 | 40 | 5.45 | 5.94 | – |
| 1 | 40 | 5.45 | 6.43 | 0.48 |
| 1.5 | 40 | 5.45 | 6.90 | 0.47 |
| 2 | 40 | 5.45 | 7.35 | 0.46 |
| 2.5 | 40 | 5.45 | 7.80 | 0.45 |
| 3 | 40 | 5.45 | 8.24 | 0.44 |
| 3.5 | 40 | 5.45 | 8.67 | 0.43 |
| 4 | 40 | 5.45 | 9.09 | 0.42 |
| 4.5 | 40 | 5.45 | 9.49 | 0.41 |
| 5 | 40 | 5.45 | 9.89 | 0.40 |

**(F)**

| Cv | Cse | Csh | Ct | ΔC |
|---|---|---|---|---|
| 0.5 | 1 | 1.17 | 1.50 | – |
| 1 | 1 | 1.17 | 1.67 | 0.17 |
| 1.5 | 1 | 1.17 | 1.77 | 0.10 |
| 2 | 1 | 1.17 | 1.84 | 0.07 |
| 2.5 | 1 | 1.17 | 1.88 | 0.05 |
| 3 | 1 | 1.17 | 1.92 | 0.04 |
| 3.5 | 1 | 1.17 | 1.95 | 0.03 |
| 4 | 1 | 1.17 | 1.97 | 0.02 |
| 4.5 | 1 | 1.17 | 1.99 | 0.02 |
| 5 | 1 | 1.17 | 2.00 | 0.02 |

, FIG. 4

(A)

(B)

(C)

_ FIG. 5

(A)

(B)

FIG. 6

<table>
<tr><td colspan="2" align="center"><strong>INTERNATIONAL SEARCH REPORT</strong></td><td>International application No.<br>PCT/JP2010/055181</td></tr>
</table>

**A. CLASSIFICATION OF SUBJECT MATTER**
*H01G5/40*(2006.01)i, *H01G5/16*(2006.01)i, *H01P1/00*(2006.01)i, *H03H7/38*
(2006.01)i

According to International Patent Classification (IPC) or to both national classification and IPC

**B. FIELDS SEARCHED**

Minimum documentation searched (classification system followed by classification symbols)
H01G5/40, H01G5/16, H01P1/00, H03H7/38

Documentation searched other than minimum documentation to the extent that such documents are included in the fields searched

| | | | |
|---|---|---|---|
| Jitsuyo Shinan Koho | 1922–1996 | Jitsuyo Shinan Toroku Koho | 1996–2010 |
| Kokai Jitsuyo Shinan Koho | 1971–2010 | Toroku Jitsuyo Shinan Koho | 1994–2010 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 8-172030 A (Xerox Corp.),<br>02 July 1996 (02.07.1996),<br>paragraphs [0005] to [0009], [0016]; fig. 7<br>& US 5644349 A | 1,2,5 |
| Y | JP 2008-236386 A (Sony Corp.),<br>02 October 2008 (02.10.2008),<br>paragraph [0009]; fig. 12<br>(Family: none) | 1,2,5 |

[X] Further documents are listed in the continuation of Box C.     [ ] See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>25 May, 2010 (25.05.10) | Date of mailing of the international search report<br>08 June, 2010 (08.06.10) |
|---|---|
| Name and mailing address of the ISA/<br>Japanese Patent Office | Authorized officer |
| Facsimile No. | Telephone No. |

Form PCT/ISA/210 (second sheet) (July 2009)

**INTERNATIONAL SEARCH REPORT**

| International application No. |
| --- |
| PCT/JP2010/055181 |

C (Continuation). DOCUMENTS CONSIDERED TO BE RELEVANT

| Category* | Citation of document, with indication, where appropriate, of the relevant passages | Relevant to claim No. |
| --- | --- | --- |
| Y | Microfilm of the specification and drawings annexed to the request of Japanese Utility Model Application No. 63272/1989(Laid-open No. 2624/1991) (NEC Corp.), 11 January 1991 (11.01.1991), entire text; fig. 1 to 4 (Family: none) | 1,2,5 |
| A | JP 63-204806 A (Hitachi Denshi, Ltd.), 24 August 1988 (24.08.1988), entire text; all drawings (Family: none) | 1-12 |
| A | JP 7-273547 A (Nihon Dempa Kogyo Co., Ltd.), 20 October 1995 (20.10.1995), entire text; fig. 2, 6 (Family: none) | 1-12 |

Form PCT/ISA/210 (continuation of second sheet) (July 2009)

**EP 2 416 330 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2003258502 A